Europäisches Patentamt

European Patent Office

Office européen des brevets

(19)

(11) Publication number: **0 189 319 B1**

# EUROPEAN PATENT SPECIFICATION

(12)

(45) Date of publication of patent specification: **31.07.91**    (51) Int. Cl.⁵: **H03L 7/18**

(21) Application number: **86300436.2**

(22) Date of filing: **22.01.86**

(54) Phase-locked loop.

(30) Priority: **23.01.85 JP 9263/85**
**23.01.85 JP 9267/85**

(43) Date of publication of application:
**30.07.86 Bulletin  86/31**

(45) Publication of the grant of the patent:
**31.07.91 Bulletin  91/31**

(84) Designated Contracting States:
**AT DE FR GB NL**

(56) References cited:
**DE-A- 3 212 655**
**FR-A- 2 401 557**
**GB-A- 1 455 821**
**GB-A- 2 097 206**
**GB-A- 2 107 142**

(73) Proprietor: **SONY CORPORATION**
**7-35 Kitashinagawa 6-Chome Shinagawa-ku**
**Tokyo 141(JP)**

(72) Inventor: **Tatami, Mitsushige**
**c/o Sony Corporation 6-7-35, Kitashinagawa**
**Shinagawa-ku Tokyo(JP)**

(74) Representative: **Ayers, Martyn Lewis Stanley**
**et al**
**J.A. KEMP & CO. 14 South Square Gray's Inn**
**London, WC1R 5EU(GB)**

## Description

The present invention relates to a phase locked loop and more particularly to a phase locked loop which is suitable for the case where the ratio between the input signal and output signal is not a simple integer.

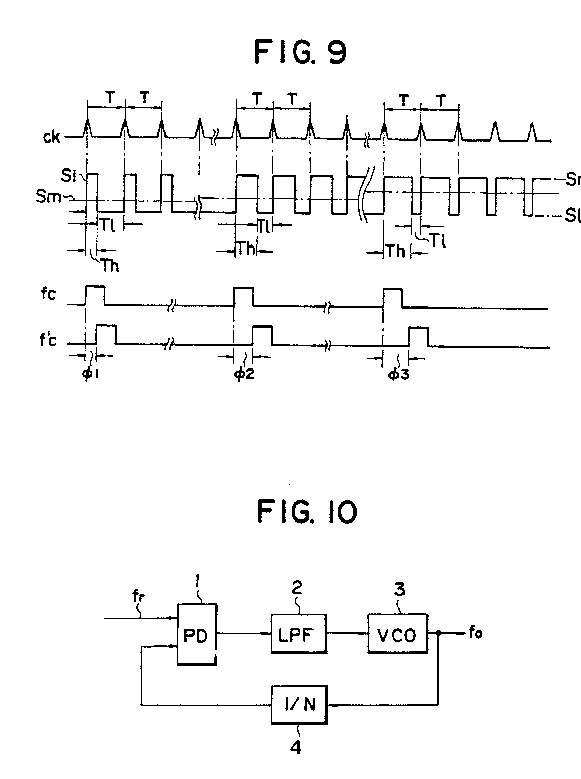

A phase locked loop (PLL) is generally formed of a phase comparator 1, low-pass filter 2, voltage-controlled oscillator 3, and a frequency dividing circuit 4 as shown in figure 10, and the output $f_o$ is synchronised with the input frequency $f_r$ in the relationship

$$f_o = Nf_r,$$

where N is the dividing ratio of the frequency dividing circuit 4.

In a TBC (Time Base error Corrector) for removing the jitter along the time axis of a regenerated video signal, however, a phase locked loop in which the ratio between the input frequency and output frequency is not a simple integer is required for restoration of the interleave of the luminance signal and colour signal.

That is, the colour subcarrier frequency $f_{sc}$ in the PAL system is set up such that:

$$f_{sc} = (1135/4)f_H + (1/2)f_V,$$

where
$f_H$ = horizontal scanning frequency and
$f_V$ = vertical scanning frequency.

Since the offset frequency $(1/2)f_V$ is added as above, in the case where the colour subcarrier frequency $f_{sc}$ is formed with the horizontal scanning frequency $f_H$ taken as the reference signal, the colour subcarrier frequency for the PAL system cannot be formed by the phase locked loop as indicated in figure 10.

GB-A-2097206 discloses a phase locked loop (PLL) circuit according to the precharacterising part of claim 1.

It is an object of the invention to provide a phase locked loop which will produce the output in synchronism with the input signal even if the ratio between the input frequency and output frequency is not a simple integer, that is, for example in the case where

$$f_o = Nf_r + \Delta f.$$

A further object of the invention is to provide a phase locked loop which, in a processing circuit for processing the colour television signal of the PAL system, will generate a colour subcarrier frequency in synchronism with the horizontal synchronising signal.

The present invention provides a phase locked loop comprising:

a variable frequency oscillator for generating the output signal in response to a control signal controlling the frequency of the output signal;

a frequency divider supplied with the output signal for frequency dividing the output signal; and

a phase comparator having first and second inputs, the first input supplied, in use, with the reference signal, for generating the control signal supplied to said variable frequency oscillator;

in which in order to generate as the output signal a signal whose phase is locked onto that of a reference signal and whose frequency thereof is provided with an offset with reference to an integral multiple of the frequency of the reference signal, said phase locked loop further comprises:

a shift control signal generator for generating a shift control signal;

a phase modulator supplied with the output of said frequency divider and the shift control signal for shifting the phase of the output of said frequency divider, the resulting phase shifted output being supplied to the second input of the phase comparator, the phase shift amount caused by said phase modulator being increased with time until said shift control signal generator is reset;

means for changing the effective division ratio of said frequency divider and resetting said shift control signal generator at intervals determined by the offset frequency required, characterised in that the changing means includes a counter for counting the cycles of the output signal and generating a carry signal when it counts a predetermined number of cycles of the output signal determined by the length of said intervals, a pulse generator supplied with the carry signal for generating a pulse with a pulse width determined by the changed dividing ratio, and a gate means supplied with the output signal and said pulse for interrupting the

2

output signal to be supplied to said frequency divider during the pulse width of said pulse.

Since the phase modulator whose phase shift amount linearly varies and the dividing ratio of the frequency dividing circuit in the phase locked loop are controlled with the period relative to the offset frequency, the phase locked loop is able to generate an output frequency such that will be the sum of the input frequency or an integral multiple thereof and a small offset frequency.

The invention will be further described by way of non-limitative example with reference to the accompanying drawings, in which:-

Fig. 1 is a block diagram showing the principle of a phase locked loop of the present invention;

Fig. 2 is an operational waveform chart of the device of Fig. 1;

Fig. 3 is a circuit diagram for showing more concretely the phase locked loop of the invention;

Fig. 4 is a waveform chart for the principal parts of the device of Fig. 3;

Fig. 5 is a block diagram showing a phase locked loop for generating a color subcarrier for the PAL system;

Fig. 6 is a waveform chart for describing the device of Fig. 5;

Fig. 7 is a block diagram showing another embodiment of the invention in which the phase modulating circuit has been improved;

Fig. 8 is a block diagram showing the portion of the phase modulator extracted from Fig. 7;

Fig. 9 is a waveform chart for the principal parts of the device of Fig. 8; and

Fig. 10 is a block diagram showing a general phase locked loop.

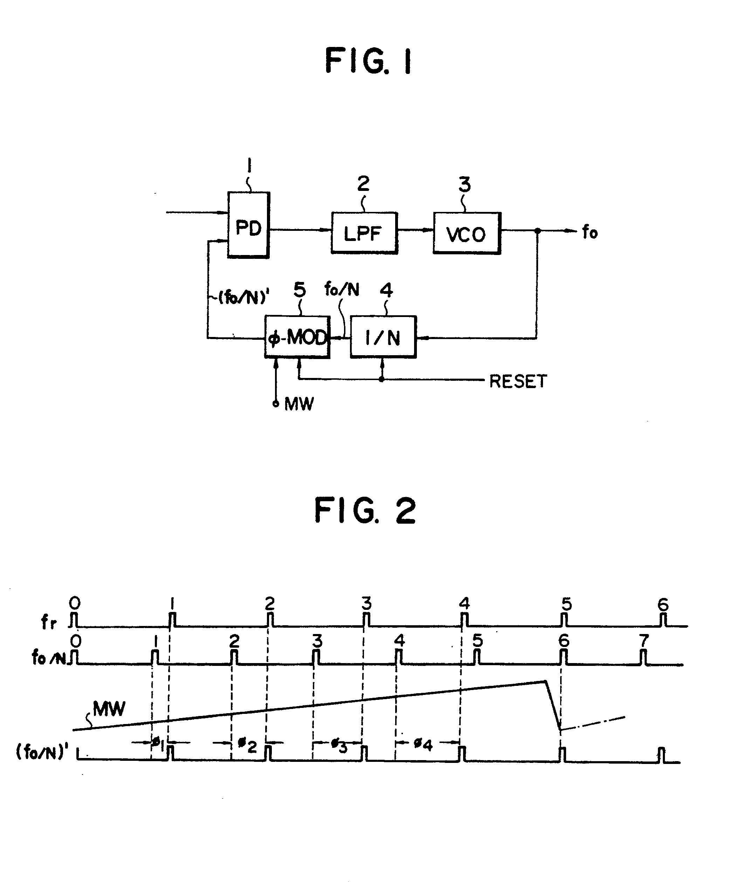

Fig. 1 is a block diagram showing a phase locked loop (hereafter to be referred to as a PLL circuit) of one embodiment of the invention, wherein, the same as in Fig. 10, 1 denotes a phase comparator, 2 denotes a low-pass filter, 3 denotes a voltage-controlled oscillator, and 4 denotes a frequency dividing circuit.

Numeral reference 5 denotes a phase modulator which performs phase modulation according to a signal supplied from outside and adapted such that, when a ramp wave, for example, is input thereto, the phase shift amount will linearly increase with time.

Accordingly, even if the divided frequency $f_o/N$ from the frequency dividing circuit 4 is in the relationship $f_r < f_o/N$ with the input frequency $f_r$ as indicated in the waveforms in Fig. 2, the output of the frequency dividing circuit 4 will be phase shifted so as to be increased every period by the phase shift amounts $\phi_1, \phi_2, \phi_3, ...$ by means of the phase modulator 5 to which the shift control wave MW of a sawtooth waveform is supplied, and eventually, the phases of the input frequency $f_r$ and phase shifted divided frequency $(f_o/N)'$ will come to coincide with each other, and the synchronism in the relationship of $f_r = f_o/N + \Delta f$ can be maintained. That is, an offset frequency $\Delta f$ can be added.

In the above case, the shift control wave MW must linearly increase the phase shift caused by the phase modulator 5 with time and this is not an easy thing to achieve. However, if it were possible to bring the signal of the input frequency $f_r$ after m clocks thereof in phase with the signal of the divided frequency $f_o/N$ after (m + 1) clocks thereof as shown in Fig. 2 (wherein the case of m = 5 is indicated), then the phase modulator 5 would be reset at that point.

But, in the case where the input frequency $f_r$ and the divided frequency $f_o/N$ have a small frequency difference ($\Delta f$) therebetween, the time period to bring the $f_r$ and $f_o/N$ in phase with each other, that is, the time period of the m clocks, will become long. In such a case, the shift control wave MW may be reset after m clocks have elapsed and the count value in the frequency dividing circuit 4 may be changed by n clocks at that point to bring them in phase.

The mentioned process may be described more generally in the following.

In the PLL circuit as described above, the output frequency $f_o$ of the voltage-controlled oscillator 3 receives the following phase shift amount $\phi(T)$ after the time period T:

$$\phi(T) = 2\pi \int_0^T f_o \cdot dt$$
$$= 2\pi (N \cdot f_r + \Delta f)T \qquad \qquad ... (1)$$

The term $2\pi N \cdot f_r \cdot T$ of the above equation (1) is the phase shift amount provided by the frequency dividing circuit 4, whereas the term $2\pi \Delta f \cdot T$ is the phase shift amount provided by the phase modulator 5.

Now, if it is expressed, using two integers m and n, such that:

3

$$(N \cdot f_r + \Delta f)T = m$$
$$\left.\right\} \quad \ldots (2)$$
$$\Delta f \cdot T = n$$

then m indicates the number of clocks of the output frequency $f_o$ to be output after the time period T, that is, the number of clocks of the voltage-controlled oscillator 3 to be counted by the frequency dividing circuit 4, and n likewise indicates the phase shift amount provided by the phase modulator 5 after the lapse of time T, converted into the number of clocks of the voltage-controlled oscillator 3.

Therefore, if the above equations (2) are applied, in the circuit of Fig. 1 it is shown that there exists the phase difference corresponding to n clocks between the input frequency $f_r$ and the divided frequency $f_{o/N}$ when the phase modulator 5 is reset at every m clocks. And so, by adapting a reset signal to be provided so that the frequency dividing circuit 4 will not count the clock signal of n clocks duration, the same can be set back to an initial phase state at the next clock. Thus, the output frequency $f_o = Nf_r + \Delta f$ providing the input frequency $f_r$ with the offset frequency ($\Delta$ f) can be formed by the PLL circuit.

From the above equations (2) are derived:

$$m/n = (N \cdot f_r)/\Delta f + 1 \quad (3)$$

$$\Delta f = n/(m - n) \cdot N \cdot f_r \quad (4)$$

and therefore, if n and m are given, the offset frequency $\Delta$ f in $f_o = N \cdot f_r + \Delta$ f can be calculated, or, conversely if the offset frequency $\Delta$ f is given, the required frequency dividing ratio N for certain integers m and n can be calculated from the equation (4).

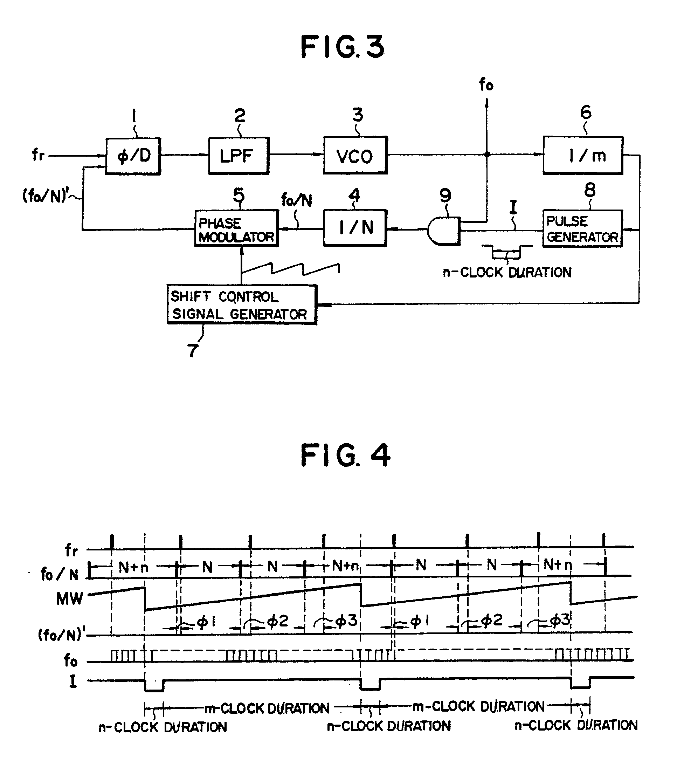

Fig. 3 is a block diagram concretely showing the circuit generating the output $f_o = N \cdot f_r + \Delta$ f based on the above described general equations, in which diagram numeral references 1 to 5 denote like parts to those in Fig. 1.

Numeral reference 6 denotes a counter for driving, upon its making m counts of the output frequency $f_o$ from the voltage-controlled oscillator 3, a pulse generator 8 constituted of a monostable multivibrator. In response to the output pulse therefrom, the shift control signal generator 7 generating a sawtooth wave is reset, and an AND gate 9 is closed, whereby the division ratio of the frequency dividing circuit 4 is increased by the duration corresponding to n clocks in substance.

By the described arrangement of the PLL circuit, as shown in Fig. 4, when the predetermined count value m is reached in the counter 6 for counting the number of clocks of the output frequency $f_o$ of the voltage-controlled oscillator 3, the shift control wave (sawtooth wave) MW from the shift control signal generator 7 is reset and, at the same time, the pulse generator 8 is driven to output a gate pulse I and by this gate pulse the input clock pulses of n clock duration is blocked to be supplied to the frequency dividing circuit 4. Therefore, the frequency dividing circuit 4 is adapted to count N + n in substance only for this time period.

And, the clocks of the output $f_o$/N of the frequency dividing circuit 4 are linearly shifted by $\phi_1 < \phi_2 < \phi_3 < \ldots$ according to the levels of the shift control wave MW which is supplied to the phase modulator 5, and thus, the output ($f_o$/N)' synchronised with the input frequency $f_r$ is formed.

Therefore, according to the present PLL circuit, the difference $\Delta$ f between the input frequency $f_r$ and output frequency $f_o$/N can be arbitrarily established with certain integers m and n assigned and it has been made possible to provide a PLL circuit which produces a synchronized condition even if the $\Delta$ f is of very small value.

By the way, in Fig. 3, it may also be possible to adapt the frequency dividing circuit 4 to be directly controlled by the output of the counter 6 so that its dividing ratio will become 1/(N + n). This will be practiced, for example, by the use of the frequency dividing circuit formed of a counter, into which a preset count value is to be loaded, this counter being counted down by the input signal and the frequency divided output being provided by decoding that the count value of the counter is zero. In such an arrangement, the preset count value may be changed according to the output of the counter 6.

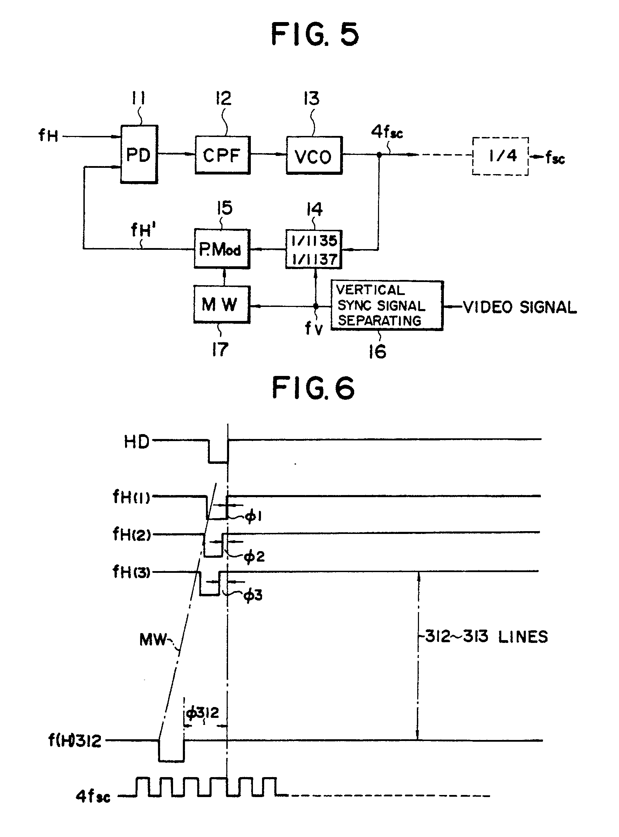

Fig. 5 indicates an embodiment of the PLL circuit of the invention for forming the previously described color subcarrier frequency $f_{sc}$ of the PAL system. Referring to the drawing, 11 denotes a phase comparator, 12 denotes a low-pass filter, 13 denotes a voltage-controlled oscillator, 14 denotes a frequency dividing circuit switchable to either of two dividing ratios of 1135 and 1137, 15 denotes a phase shifter, 16 denotes a vertical synchronizing signal separating circuit, and 17 denotes a shift control signal generator.

The color subcarrier frequency $f_{sc}$ of the PAL system is as described previously defined by

$$4 f_{sc} = 1135 f_H + 2 f_V.$$

From the above equation is derived

$$(4/1135)f_{sc} = f_H + (2/1135)f_V,$$

which means that $(4/1135)f_{sc}$ has a frequency difference ($\Delta$ f) of $(2/1135)f_V$ with reference to the horizontal scanning frequency $f_H$.

This accounts for $(2/1135) \cdot 2\pi$ of phase difference for one field, namely, it corresponds to 2-clock phase difference of the 4 $f_{sc}$ clock signal.

Therefore, the purpose is attained by adapting the frequency dividing circuit 14 to ignore the clock signal of n = 2 clocks duration for each field in the manner as described above and the shift control signal generator 17 to be reset at the interval of one field corresponding to the above described m-clock period.

Fig. 6 indicates phase shift amounts in the signal f(H) output from the phase shifter 15 for each horizontal synchronizing signal H, wherein f(H)312, or the maximum phase shift amount to be provided at the end of one field, is indicated by $\phi_{312}$.

The maximum phase shift time duration is $2/(4f_{sc}) \fallingdotseq 113$ $\mu$ s, which corresponds to 2 clocks of the color subcarrier 4 $f_{sc}$.

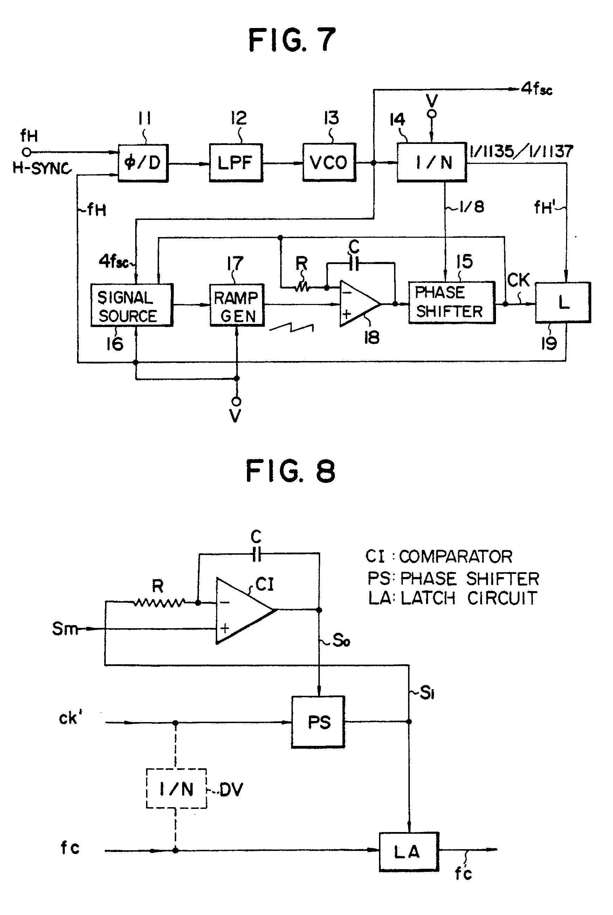

Fig. 7 is a block diagram showing an embodiment of the invention of the phase locked loop suitable for outputting a color subcarrier of the PAL system. Referring to the drawing, the same as in Fig. 5, 11 denotes a phase comparator, 12 denotes a low-pass filter, 13 denotes a voltage-controlled oscillator, 14 denotes a frequency dividing circuit whose dividing ratios are switchable either to 1/1135 or to 1/1137, and 15 denotes a phase shifter.

Reference numeral 16 denotes a signal source of current (voltage) capable of providing the maximum phase shift amount ($\phi$) at the time point when the vertical synchronizing signal V is obtained as described above and its output value is adapted to be supplied to a sawtooth wave generator 17. Reference numeral 18 denotes an integrating circuit for integrating the difference of the signals supplied thereto and 19 denotes a latch circuit.

In this embodiment, the same as in the example of the above described Fig. 5, the dividing ratio of the frequency dividing circuit 14 is changed from 1135 to 1137 corresponding to the 2-clock duration by the vertical synchronizing signal V to be output for each field and, further, the sawtooth wave generator 17 for providing the phase shift amount of the phase shifter 15 is reset at the same time.

With reference to the ramp angle of the sawtooth wave determining the phase shift amount, the maximum phase shift amount at the time when the vertical synchronizing signal V is obtained is compensated by the signal source 16 through comparison of the output of the phase shifter 15 with the output of the voltage-controlled oscillator 13, and so, specifically changes in the phase shift amount due to temperature variation can be eliminated.

Further, the phase shifter 15 is supplied with the clock of higher frequency than $(4/1135)$ $f_{sc}$, that of $(1/8)$ $f_{sc}$ for example, and phase shifting is achieved by causing the latch circuit 19 to latch the output of the frequency dividing circuit 14 by the output of the phase shifter 15.

Therefore, the shift amount of the phase shifter 15 and the duty of the clock period becomes high and the loop gain including the integrating circuit 18 becomes high, and thus, the effect is produced that the linearity of the phase shift amount is improved.

Now, operations of the phase modulator as indicated in Fig. 7 and the reason why linearity of the phase shift amount is improved by the use of this phase modulator will be described referring to Figs. 8 and 9.

Fig. 8 is a block diagram showing the portion of the phase modulator extracted from Fig. 7, wherein CI, corresponding to 18 in Fig. 7, denotes a comparator supplied with a shift control wave $S_m$ at one input terminal thereof and with a modulated signal $S_i$ which has been phase shifted at the other input terminal, and the difference signal from the comparator is output as a signal integrated by resistor R and capacitor C.

And, PS, corresponding to 15 in Fig. 7, denotes a phase shifter formed of a monostable multivibrator, a variable delay circuit, etc. and LA denotes a latch circuit corresponding to 19 in Fig. 7.

Operations of the phase modulator indicated in Fig. 8 will be described below with reference to the waveform chart of Fig. 9.

The phase shifter PS is supplied with a sub signal CK' (1/8 $f_{sc}$ in the example of Fig. 7) to be modulated and this signal is converted into a modulated signal $S_i$ whose pulse widths vary in accordance with the levels of the control signal $S_o$ output from the comparator CI.

5

Assuming now that "H" level periods $T_h$ and "L" level periods $T_l$ of the modulated signal $S_i$ vary according to the levels of the shift control wave $S_m$ as indicated in the waveform chart of Fig. 9, the control signal $S_o$ from the comparator CI will be expressed by

$$S_o = 1/(RC) \int_0^{nT} (S_i - S_m) dt \qquad \ldots (5)$$

where T is the period of the sub signal (clock signal) CK'.

Representing the value of the "H" level by $S_h$ and that of the "L" level by $S_l$, the above equation (5) will become

$$S_o = -(n/RC)\{(S_h - S_m) \cdot T_h + (S_l - S_m) \cdot T_l\} \qquad (6)$$

Since $T_l = T - T_h$, the equation (6) may be transformed into

$$S_o = -(n/RC)\{(S_l - S_m) \cdot T + (S_h - S_l) \cdot T_h\} \qquad (7)$$

If it is assumed here that there is a relationship:

$$T_h = K \cdot S_o \qquad (8)$$

between the control signal $S_o$ and the "H" level pulse period $T_h$ due to the modulation characteristic K of the phase shifter PS, then

$$T_h = K \cdot S_o = -K \cdot (n/RC)\{(S_l - S_m) \cdot T + (S_h - S_l) \cdot T_h\} \qquad (9)$$

Therefore,

$$T_h = \{-K(n/RC)(S_l - S_m) \cdot T\}/\{l + K(n/RC)(S_h - S_l)\} \qquad (10)$$

Since it is possible to put $n \to \infty$ at a steady state,

$$T_h = (S_m - S_l)/(S_h - S_l) \cdot T \qquad (11)$$

As understood from the above equation (11), if the feedback loop is structured by the comparator CI, the phase shift amount ($T_h$) is independent of the modulation characteristic K of the phase shifter PS and good linearity of the phase shift is achieved.

And, if we take out from the equation (11) the relationships between the level values ($S_h$, $S_l$) of the modulated signal $S_i$ and the "H" level pulse width $T_h$ which indicates the phase shift amount, we obtain:

$$dT_h/dS_h = -\{(S_m - S_l)/(S_h - S_l)^2\} \cdot T \qquad (12)$$

$$dT_h/dS_l = -\{(S_m - S_h)/(S_h - S_l)^2\} \cdot T \qquad (13)$$

from which it is known that, even if the level values $S_h$, $S_l$) of the modulated signal $S_i$ may vary due to the temperature characteristic, for example, the phase shift amount ($T_h$) becomes less variable the smaller the period T of the sub signal to be modulated CK' is.

Therefore, the phase modulator of the present invention is arranged so that the sub signal CK' to be modulated which is input to the phase shifter PS will have a higher frequency than the main signal $f_c$ to be modulated and, as the result of the shortened period T, the ratio of the phase shift amount ($T_h$) thereto, that is, the duty factor $T_h/T$ will become larger.

By so doing, the gain of the feedback loop including the comparator CI becomes larger and the variation in the phase shift amount due to change in the temperature of the circuit can be suppressed.

The main signal $f_c$ to be modulated as the real object of modulation is adapted to be latched by the latch circuit LA according to the modulated signal $S_i$ output from the phase shifter PS and thereby provided with phase shift amounts $\phi_1$, $\phi_2$, $\phi_3$, ... .

Although in the above described embodiments, the circuit was structured such that the phase modulation is made after the frequency division, the PLL circuit may be structured such that the frequency division will be made after the phase modulation. And, it will also be possible to apply phase modulation to the input frequency $f_r$ serving as the reference signal.

As described so far, the phase locked loop of the present invention has been arranged such that a PLL circuit is provided with a phase modulating circuit for linearly changing the phase and the phase modulating circuit is adapted to be reset at an interval of the period related to the offset frequency and the dividing ratio of the frequency dividing circuit is controlled so that the initial phase relationship is provided at the mentioned resetting time point. Thus, an effect is obtained that an output frequency having a small offset frequency with respect to the input frequency can be formed easily.

## Claims

1. A phase locked loop comprising:

   a variable frequency oscillator (3) for generating the output signal in response to a control signal controlling the frequency of the output signal;

   a frequency divider (4) supplied with the output signal for frequency dividing the output signal; and

   a phase comparator (1) having first and second inputs, the first input supplied, in use, with the reference signal, for generating the control signal supplied to said variable frequency oscillator;

   in which in order to generate as the output signal a signal whose phase is locked onto that of a reference signal and whose frequency thereof is provided with an offset with reference to an integral multiple of the frequency of the reference signal, said phase locked loop further comprises:

   a shift control signal generator (7) for generating a shift control signal (MW);

   a phase modulator (5) supplied with the output (Fo/N) of said frequency divider and the shift control signal (MW) for shifting the phase of the output of said frequency divider, the resulting phase shifted output being supplied to the second input of the phase comparator (1), the phase shift amount caused by said phase modulator (5) being increased with time until said shift control signal generator (7) is reset;

   means (6, 8) for changing the effective division ratio of said frequency divider and resetting said shift control signal generator at intervals determined by the offset frequency required, characterised in that the changing means includes a counter (6) for counting the cycles of the output signal and generating a carry signal when it counts a predetermined number of cycles of the output signal determined by the length of said intervals, a pulse generator (8) supplied with the carry signal for generating a pulse with a pulse width determined by the changed dividing ratio, and a gate means (9) supplied with the output signal and said pulse for interrupting the output signal to be supplied to said frequency divider during the pulse width of said pulse.

2. A phase locked loop according to claim 1 wherein said shift control signal is a ramp signal (MW) whose level is linearly increased.

3. A phase locked loop according to claim 1 or 2 wherein said reference signal is a horizontal synchronising signal (H-SYNC, figure 7) of a colour television signal of the PAL system and the output signal is of the frequency four times as high as the colour subcarrier frequency.

4. A phase locked loop according to any one of the preceding claims wherein said changing means includes a vertical synchronising signal separating circuit (16) for separating a vertical synchronising signal from a composite colour television signal of the PAL system, the vertical synchronising signal being supplied to said frequency divider (14) and said shift control signal generator (17).

5. A phase locked loop according to any one of the preceding claims wherein said phase modulator (15) includes a phase shifter (PS, figure 8) for shifting the phase of a signal whose frequency is higher than that of the output of said frequency divider and latch circuit (LA) for latching the output of said frequency divider by the output of said phase shifter.

6. A phase locked loop according to claim 5 wherein said phase modulator (15) further includes a comparator (CI) for comparing a shift control signal and the output of said phase shifter and supplying its output to said phase shifter, said comparator (CI) having a capacitor (C) connected between its output and the input to be supplied with the output of said phase shifter.

**Revendications**

1. Boucle d'asservissement de phase comprenant :
   un oscillateur à fréquence variable (3) servant à produire un signal de sortie en fonction d'un signal de commande qui commande la fréquence du signal de sortie ;
   un diviseur de fréquence (4) recevant le signal de sortie et servant à diviser en fréquence le signal de sortie ; et
   un comparateur de phase (1) qui possède une première et une deuxième entrée, la première entrée recevant, en utilisation, un signal de référence, et servant à produire le signal de commande fourni audit oscillateur à fréquence variable ;
   dans laquelle, pour produire comme signal de sortie un signal dont la phase est asservie sur celle d'un signal de référence et dont la fréquence comporte un décalage par rapport à un multiple entier de la fréquence du signal de référence, ladite boucle d'asservissement de phase comprend en outre :
   un générateur de signal de commande de décalage (7) servant à produire un signal de commande de décalage (MW) ;
   un modulateur de phase (5) recevant le signal de sortie (Fo/N) dudit diviseur de fréquence et le signal de commande de décalage (MW) et servant à décaler la phase, c'est-à-dire déphaser, du signal de sortie dudit diviseur de fréquence, le signal de sortie déphasé résultant étant fourni à la deuxième entrée du comparateur de phase (1), l'amplitude de déphasage produite par ledit modulateur de phase (5) augmentant avec le temps jusqu'à ce que ledit générateur de signal de commande de décalage (7) soit repositionné ;
   un moyen (6, 8) servant à modifier le rapport de division effectif dudit diviseur de fréquence et à repositionner ledit générateur de signal de commande de décalage à des intervalles qui sont déterminés par la fréquence de décalage demandée, caractérisée en ce que le moyen de modification comporte un compteur (6) servant à compter les cycles du signal de sortie et à produire un signal de report lorsqu' il a compté un nombre prédéterminé de cycles du signal de sortie qui est déterminé par la longueur desdits intervalles, un générateur d'impulsion (8) recevant le signal de report et servant à produire une impulsion ayant une largeur d'impulsion qui est déterminée par le rapport de division modifié, et un moyen du type porte (9) recevant le signal de sortie et ladite impulsion et servant à interrompre la fourniture du signal de sortie audit diviseur de fréquence pendant la largeur d'impulsion de ladite impulsion.

2. Boucle d'asservissement de phase selon la revendication 1, où ledit signal de commande de décalage est un signal en rampe (MW) dont le niveau augmente linéairement.

3. Boucle d'asservissement de phase selon la revendication 1 ou 2, où ledit signal de référence est le signal de synchronisation horizontale (H-SYNC, figure 7) d'un signal de télévision en couleur du système PAL et le signal de sortie a une fréquence quatre fois plus élevée que la fréquence de la sous-porteuse de chrominance.

4. Boucle d'asservissement de phase selon l'une quelconque des revendications précédentes, où ledit moyen de modification comporte un circuit de séparation de signal de synchronisation verticale (16) servant à séparer d'un signal de télévision en couleur composite du système PAL le signal de sychronisation verticale, le signal de synchronisation verticale étant fourni audit diviseur de fréquence (14) et audit générateur de signal de commande de décalage (17).

5. Boucle d'asservissement de phase selon l'une quelconque des revendications précédentes, où ledit modulateur de phase (15) comporte un déphaseur (PS, figure 8) servant à décaler la phase, c'est-à-dire déphaser, d'un signal dont la fréquence est plus élevée que celle du signal de sortie dudit diviseur de fréquence et un circuit de verrouillage (LA) servant à verrouiller le signal de sortie dudit diviseur de fréquence à l'aide du signal de sortie dudit déphaseur.

6. Boucle d'asservissement de phase selon la revendication 5, où ledit modulateur de phase (15) comporte en outre un comparateur (CI) servant à comparer un signal de commande de décalage et le signal de sortie dudit déphaseur et à fournir son signal de sortie audit déphaseur, ledit comparateur (CI) comportant un condensateur (C) qui est connecté entre sa sortie et l'entrée qui doit recevoir le signal de sortie dudit déphaseur.

## Patentansprüche

1. Phasenregelschleife mit

einem frequenzvariablen Oszillator (3) zur Erzeugung des Ausgangssignals in Abhängigkeit von einem die Frequenz des Ausgangssignals bestimmenden Steuersignal,

einem mit dem Ausgangssignal beaufschlagten Frequenzteiler (4) zum Teilen der Frequenz des Ausgangssignals und

einem Phasenkomparator (1) zur Erzeugung des dem frequenzvariablen Oszillator (3) zugeführten Steuersignals, wobei dieser Phasenkomparator einen ersten und einen zweiten Eingang aufweist und dem ersten Eingang im Betrieb ein Referenzsignal zugeführt wird,

wobei die Phasenregelschleife für die Erzeugung eines Signals als Ausgangssignal, dessen Phase mit der Phase des Referenzsignals verriegelt ist und dessen Frequenz gegenüber einem ganzzahligen Vielfachen der Frequenz des Referenzsignals mit einem Offset beaufschlagt ist, weiterhin enthält:

einen Schiebe-Steuersignal-Generator (7) zur Erzeugung eines Schiebe-Steuersignals (MW),

einen mit dem Ausgangssignal (Fo/N) des Frequenzteilers und dem Schiebe-Steuersignal (MW) beaufschlagten Modulator (5) zum Verschieben der Phase des Ausgangssignals des Frequenzteilers, wobei das resultierende phasenverschobene Ausgangssignal dem zweiten Eingang des Phasenkomparators (1) zugeführt wird und wobei die von dem Phasen-Modulator (5) verursachte Phasenverschiebung in der Zeit ansteigt, bis der Schiebe-Steuersignal-Generator (7) zurückgesetzt wird,

eine Änderungseinrichtung (6, 8) zum Ändern des effektiven Teilerverhältnisses des Frequenzteilers und zum Rücksetzen des Schiebe-Steuersignal-Generators in Intervallen, die durch die erforderliche Offset-Frequenz bestimmt sind,

**dadurch gekennzeichnet,**

daß diese Änderungseinrichtung umfaßt

- einen Zähler (6), der die Zyklen des Ausgangssignals zählt und ein Übertragsignals erzeugt, wenn er eine durch die Länge der genannten Intervalle festgelegte vorbestimmte Anzahl von Zyklen des Ausgangssignals zählt,
- einen mit dem Übertragsignal beaufschlagten Impulsgenerator (8) zur Erzeugung eines Impulses, dessen Impulsbreite durch das geänderte Teilerverhältnis bestimmt wird, und
- eine mit dem Ausgangssignal und dem genannten Impuls beaufschlagte Torschaltung (9) zur Unterbrechung des während der Impulsgeneratorbreite des Impulses dem Frequenzteiler zuzuführenden Ausgangssignals.

2. Phasenregelschleife nach Anspruch 1, bei der das Schiebe-Steuersignal ein Rampensignal (MW) mit linear anwachsenem Pegel ist.

3. Phasenregelschleife nach Anspruch 1 oder 2, bei der das Referenzsignal das horizontale Synchronisiersignal (HSYNC, Fig. 9) eines Farbfernsehsignals nach dem PAL-System ist und bei der die Frequenz des Ausgangssignals vier mal so groß ist wie die Frequenz des Farbhilfsträgers.

4. Phasenregelschleife nach einem der vorhergehenden Ansprüche, bei der die Änderungseinrichtung eine Vertikal-Synchronisiersignal-Trennschaltung (16) aufweist zum Abtrennen eines Vertikal-Synchronisiersignals aus einem Farbfernsehsignalgemisch nach dem PAL-System und bei der dieses Vertikal-Synchronisiersignal dem Frequenzteiler (14) und Schiebe-Steuersignal-Generator (17) zugeführt wird.

5. Phasenregelschleife nach einem der vorhergehenden Ansprüche, bei der der Phasen-Modulator (5) einen Phasenschieber (PS, Fig. 8) aufweist zum Verschieben der Phase eines Signals, dessen Frequenz größer ist als diejenige des Ausgangssignals des Frequenzteilers, sowie eine Verriegelungsschaltung (LA) zum Verriegeln des Ausgangssignals des Frequenzteilers durch das Ausgangssignal des Phasenschiebers.

6. Phasenregelschleife nach Anspruch 5, bei der der Phasen-Modulator (15) ferner einen Komparator (CI) aufweist, der ein Schiebe-Steuersignal und das Ausgangssignal des Phasenschiebers vergleicht und sein Ausgangssignal dem Phasenschieber zuführt, wobei dieser Komparator (CI) einen Kondensator (C) enthält, der zwischen seinem Ausgang und dem mit dem Ausgangssignal des Phasenschieber beaufschlagten Eingang angeordnet ist.

# FIG. 1

# FIG. 2

# FIG.3

# FIG. 4

# FIG. 5

# FIG. 6

# FIG. 7

# FIG. 8

CI : COMPARATOR
PS : PHASE SHIFTER
LA : LATCH CIRCUIT

# FIG. 9

# FIG. 10